# EUROPEAN PATENT SPECIFICATION

(11) **EP 0 430 562 B1**
(45) Date of publication and mention of the grant of the patent: **14.09.1994**
(21) Application number: 90312664.7
(22) Date of filing: 20.11.1990
(51) Int. Cl.: H01L 29/267

(54) **Semiconductor heterostructure and method of producing the same**
Halbleiterheterostruktur und Verfahren zu ihrer Herstellung
Hétérostructure semi-conductrice et méthode pour sa fabrication

(30) Priority: 20.11.1989 JP 299758/89
(43) Date of publication of application: 05.06.1991
(73) Proprietor: FUJITSU LIMITED, Kawasaki-shi, Kanagawa 211 (JP)
(72) Inventor: Takasaki, Kanetake, Tokyo 143 (JP)
(74) Representative: Silverman, Warren

(56) References cited:
- EP-A- 0 288 681
- EP-A- 0 326 832
- US-A- 4 716 445
- APPLIED PHYSICS LETTERS, vol. 47, no. 4, August 1985, pages 397-399,American Institute of Physics, Woodbury, New York, US; R. FISCHER et al.: "GaAs bipolar transistors grown on (100) Si substrates by molecular beam epitaxy"

## Description

This invention relates to a semiconductor device and a method of producing the semiconductor device and more particularly, relates to a semiconductor device having a gallium arsenide (GaAs) crystalline thin film on a silicon (Si) substrate, and to a method of producing the same.

GaAs is used to obtain a higher speed of operation than obtainable with Si and has a light emission function enabling it to be used for a LED or laser etc. Nevertheless, it is not easy to obtain a large diameter wafer of GaAs, and the mechanical strength thereof is low, and thus in practice GaAs is not used as much as Si.

In view of the above, attempts have been made to form a GaAs substrate on a Si substrate having a large diameter, which can be easily obtained and has a superior mechanical strength, and to form a device on the surface of the GaAs substrate. See, for example Applied Physics Letters vol. 47, No. 4, pages 397-399 (1985) which discloses a GaAs bipolar transistor formed on a Si substrate.

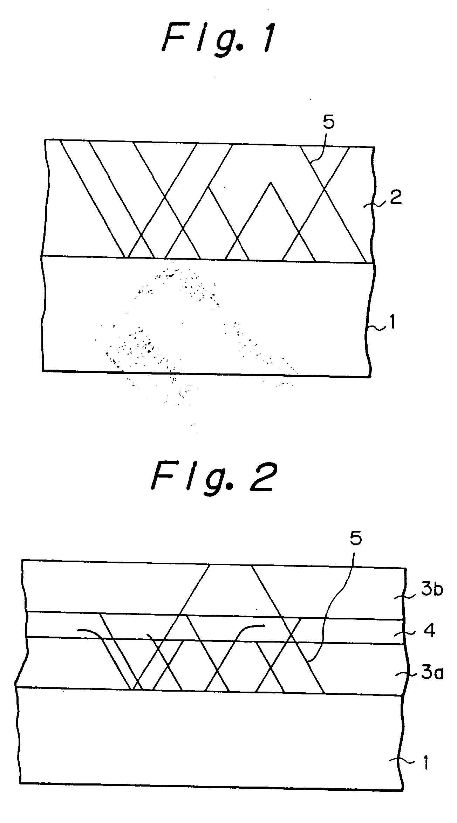

As shown in Figure 1 of the accompanying drawings, when a GaAs crystalline layer 2 is formed directly on a Si substrate 1, a number of defects, such as strain and dislocation, etc., occur due to the differences in the lattice constants thereof and in the thermal expansion coefficients at the interface between the GaAs crystalline layer 2 and the Si substrate 1, and these defects are propagated to the upper layer, and thus a device having good electrical properties cannot be obtained. Namely, when for example a MES FET or a HEMT, etc. is formed, the threshold voltage is varied. Therefore, a method of directly reducing the crystal defects of about 10⁷ to 10⁸/cm² in the GaAs crystalline layer also has been considered.

To reduce the crystal defects, for example, after a GaAs crystalline layer is grown on a Si substrate, a thermal cycle of annealing in which, for example, a heat treatment at a temperature of 200°C for 10 min., and subsequently, at a temperature of 800°C for 10 min, has been carried out. Also, to reduce the crystal defects, a half-thickness GaAs layer is first grown subsequently, the above-mentioned annealing thermal cycle is effected and then a GaAs layer to provide the remaining GaAs thickness is formed.

Nevertheless, in the above-mentioned GaAs crystal defect reduction process using thermal annealing, it is difficult to lower the crystal defect density to about 1 x 10⁶, so that it has no influence on the electrical properties of an element.

Further, as a method of forming a GaAs layer on a Si substrate, it is well known that a buffer layer of Ge having a lattice constant close to that of GaAs can be formed on the Si substrate, and a GaAs layer can be formed on the buffer layer. When the buffer layer of Ge is formed on a Si substrate, a dislocation is often generated at the Si/Ge interface, due to the difference in the lattice constants of the Si and Ge of about 4%, and thus it is difficult to lower the crystal defect density of GaAs to 1 x 10⁸/cm² or less.

An object of the present invention is to provide a semiconductor device having a GaAs crystal formed on a Si substrate with a low defect density, the defect density preferably being lowered to 1 x 10⁸/cm² or less.

Therefore, according to the present invention, there is provided a semiconductor device comprising:
a crystalline substrate of Si, sapphire or MgO;
a first buffer layer formed on said Si surface and being either a GaAs or a GaAs-containing compound semiconductor layer;
a second buffer layer formed on said first buffer layer and being either a Ge or a Ge-containing crystal layer; and
a compound semiconductor layer formed on said second buffer layer and being either a GaAs or a GaAs-containing compound semiconductor.

Therefore, in the present invention, a layer of germanium (Ge) or Ge-containing crystalline layer is formed within a layer of gallium arsenide (GaAs) or GaAs-containing compound formed on a substrate of for example, silicon (Si).

When, for example, a Ge single crystalline layer is present within a GaAs layer applied to a Si substrate, since GaAs has a different crystal structure from that of Ge, i.e., GaAs has a zinc blend structure and Ge has a diamond structure, crystalline defects such as dislocation, etc., propagated from the layer below are not propagated upward but are directed horizontally. Namely, a blocking effect is generated, and thus defects are not generated in the upper surface of the Ge layer.

Since the lattice constants of GaAs and Ge are close to each other, i.e., the lattice constant of GaAs is about 0,5653 nm (5.653 Å) and the lattice constant of Ge is about 0,5658 nm (5.658 Å), a difference of about 0.09%, new defects are rarely generated at the interface between GaAs and Ge.

In the present invention, preferably the Ge or Ge-containing crystalline layer has a thickness of 5 to 200 nm (50 to 2000 Å), and the GaAs or GaAs-containing layer formed on the Ge or Ge-containing crystalline layer has a thickness of 1 to 3 µm.

According to the present invention, AlGaAs, InGaAs, GaAsP or InGaAsP, etc., the lattice constants of which are substantially the same as that of Ge, can be advantageously used instead of GaAs. Further, SiGe, etc., also can be used instead of Ge in forming the intermediate layer.

Preferably, a product of the present invention is a MES FET, a HEMT (High Electron Mobility Transistor), a photo-diode, a laser, etc.

For a better understanding of this invention and to show how the same can be carried into effect, reference will now be made, by way of example only, to the accompanying drawings, wherein:
FIGURE 1 is a schematic cross-section through a semi-conductor device for explaining the prior art;
FIGURE 2 is a schematic cross-sectional view illustrating one embodiment of the present invention;
FIGURE 3 shows the relationship between the thickness of a Ge crystalline layer (Ge film thickness) and defect density in an upper GaAs crystalline layer having a thickness of about 1.5 µm; and
FIGURE 4 illustrates the relationship between the thickness of a lower GaAs layer (under layer GaAs film thickness) and defect density in an upper GaAs layer when the Ge crystalline layer has a thickness of 500 Å.

As shown in Figure 2, on a (100) surface of a silicon (Si) substrate (wafer) 1 are provided a lower GaAs crystalline layer 3a having a thickness of about 1.5 µm, a Ge crystalline layer 4 having a thickness of about 100 nm (1000 Å), and an upper GaAs crystalline layer 3b having a thickness of about 1.5 µm.

In Figure 2, defects such as dislocation, etc., generated in the lower GaAs crystalline layer 3a are absorbed and reduced in the Ge crystalline layer 4, and only a part of any defect is propagated to the upper GaAs crystalline layer 3b.

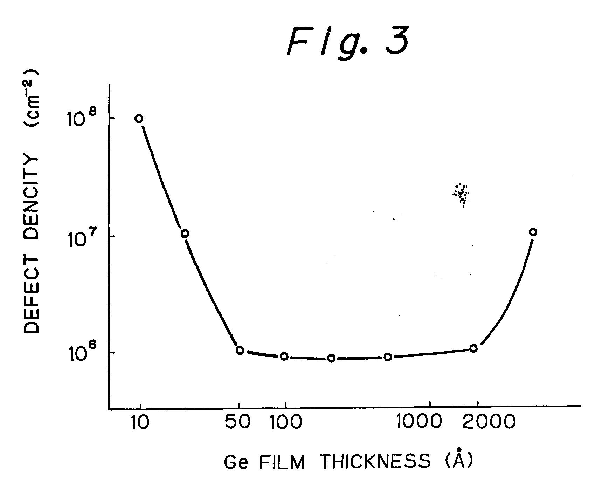

Figure 3 shows the relationship between thickness of a Ge crystalline layer (Ge film thickness) and defect density in an upper GaAs crystalline layer having a thickness of about 1.5 µm.

Figure 3 shows that the defect density of the upper GaAs crystalline layer is lowered to 1 x 10⁶/cm² when the Ge film thickness is in a range of from 5 to 200 nm (50 to 2000 Å).

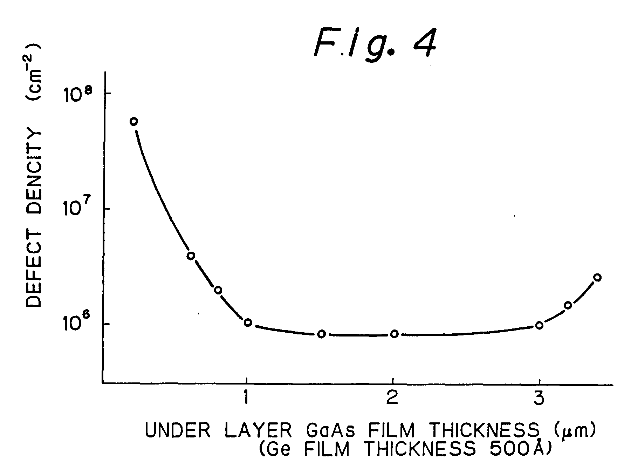

Further, Figure 4 illustrates the relationship between the thickness of a lower GaAs layer (underlayer GaAs film thickness) and defect density in an upper GaAs layer when the Ge crystalline layer has a thickness of 500 Å.

Figure 4 shows that the defect density is lowered to 1 x 10⁶/cm² when the underlayer GaAs film is in a range of from 1 to 3 µm.

Accordingly, a MES FET (not shown., having a Ge crystalline layer 4 acting as an n type substrate, an upper GaAs crystalline layer 3b acting as a p or i type substrate, and an n type electrical element can be produced and operates satisfactorily.

Further, another MES FET (not shown) having a Ge crystalline layer 4 acting as a p type substrate (using boron ion implantation) and an upper GaAs crystalline layer 3B acting as an n type substrate for an electrical element also can be obtained which operates satisfactorily.

The production of the crystalline layer shown in Figure 2 of a semiconductor device will now be explained.

First, on a (100) surface of a Si substrate 1 is formed a lower GaAs crystalline layer 3a, to a thickness of about 1.5 µm, by an MOCVD (Metal Organic Chemical Vapour Deposition) process using trimethylgallium (TMG) and arsine (AsH₃) as reaction gases, at a growth temperature of 700°C, for a growth time of about 30 min, and under a growth pressure of about 10,1 kPa (76 Torr). Although a lower GaAs crystalline layer 3a can be directly formed on the Si substrate 1, an amorphous GaAs (a-GaAs) layer is preferably formed on the Si substrate 1 before forming the lower GaAs crystalline layer 3a. The a-GaAs layer is grown to a thickness of about 20 nm (200 Å) at a temperature of 450°C.

The a-GaAs layer, can be formed flat and thus an abnormal nucleus growth can be prevented, and further, strain can be reduced by forming the a-GaAs layer. The a-GaAs layer can be single crystallized at 700°C in a later process.

Then a Ge crystalline layer is formed to a thickness of about 100 nm (1000 Å) on the lower GaAs crystalline layer 3a by the same device using germane (GeH₄) and hydrogen (H₂) as reaction gases, at a growth temperature of about 400°C, for a growth time of 10 min., and under a growth pressure of about 10,1 kPa (76 Torr).

Thereafter, an upper GaAs crystalline layer 3b is again formed to a thickness of about 1.5 µm, by the same production process as explained above.

GaAs and Ge can be also grown by an MBE (Molecular Beam Epitaxial) growth process.

Then, after the GaAs (3b)/Ge (4)/GaAs (3a) crystalline structure is formed, an electrical element such as a MES FET, a MBMT, a photo-diode or a laser can be formed on the GaAs layer 3b.

In the present invention, the same effects can be obtained by using, in place of the Si layer, sapphire or MgO etc., whose crystal form is similar to that of Si.

## Claims

1. A semiconductor device comprising:
a crystalline substrate (1) made of Si, sapphire or MgO;
a first buffer layer (3a) formed on said crystalline substrate and being either a GaAs or a GaAs-containing compound semiconductor layer;
a second buffer layer (4) formed on said first buffer layer (3a) and being either a Ge or a Ge-containing crystal layer; and
a compound semiconductor layer (3b) formed on said second buffer layer (4) and being either a GaAs or a GaAs-containing compound semiconductor.

2. A semiconductor device according to claim 1, wherein said second buffer layer (4) has a thickness in the range 5 to 200 nm.

3. A semiconductor device according to claim 1 or 2, wherein said first buffer layer (3a) has a thickness in the range 1 to 3 µm.

4. A semiconductor device according to claim 1, 2 or 3, wherein said compound semiconductor layer (3b) has a crystal defect density of 1 x 10⁶/cm² or less.

5. A semiconductor device according to claim 1, 2, 3 or 4, wherein said second buffer layer (4) is n-type and said compound semiconductor layer (3b) is p- or i-type.

6. A semiconductor device according to claim 1, 2, 3 or 4, wherein said second buffer layer (4) is p-type layer, and said compound semiconductor layer (3b) is n-type.

7. A semiconductor device according to claim 5, wherein said semiconductor device is a MESFET, HEMT, photodiode, or laser.

8. A semiconductor device according to any preceding claim, wherein said second buffer layer (4) is a SiGe crystal layer.

9. A semiconductor device according to any preceding claim, wherein said compound semiconductor layer (3b) is AlGaAs, InGaAs, GaAsP or InGaAsP.

10. A semiconductor device according to claim 6, wherein said semiconductor device is a MESFET, HEMT, photodiode or laser.

11. A semiconductor device according to any preceding claim, wherein said first buffer layer (3a) is AlGaAs, InGaAs, GaAsP or InGaAsP.

## Patentansprüche

1. Halbleitereinrichtung enthaltend:
ein kristallines Substrat (1), das aus Si, Saphir oder MgO hergestellt ist;
eine erste Pufferschicht (3a), die auf dem kristallinen Substrat ausgebildet ist und eine Halbleiterschicht aus entweder GaAs oder einer GaAs-enthaltenden Verbindung ist;
eine zweite Pufferschicht (4), die auf der ersten Pufferschicht (3a) ausgebildet ist und entweder eine Ge- oder eine Ge-enthaltende Kristallschicht ist; und
eine Verbindungshalbleiterschicht (3b), die auf der zweiten Pufferschicht (4) ausgebildet ist und entweder ein GaAs- oder ein GaAs-enthaltende Verbindungshalbleiter ist.

2. Halbleitereinrichtung nach Anspruch 1, bei der die zweite Pufferschicht (4) eine Dicke im Bereich von 5 bis 200 nm hat.

3. Halbleitereinrichtung nach Anspruch 1 oder 2, bei der die erste Pufferschicht (3a) eine Dicke im Bereich von 1 bis 3 µm hat.

4. Halbleitereinrichtung nach Anspruch 1, 2 oder 3, bei der die Verbindungshalbleiterschicht (3b) eine Kristalldefektdichte von 1 x 10⁶/cm² oder weniger hat.

5. Halbleitereinrichtung nach Anspruch 1, 2, 3 oder 4, bei der die zweite Pufferschicht (4) vom n-Typ und die Verbindungshalbleiterschicht (3b) vom p- oder i-Typ ist.

6. Halbleitereinrichtung nach Anspruch 1, 2, 3 oder 4, bei der die zweite Pufferschicht (4) eine p-Typ-Schicht ist und die Verbindungshalbleiterschicht (3b) vom n-Typ ist.

7. Halbleitereinrichtung nach Anspruch 5, bei der die Halbleitereinrichtung ein MESFET, ein HEMT, eine Photodiode oder ein Laser ist.

8. Halbleitereinrichtung nach einem der vorhergehenden Ansprüche, bei der die zweite Pufferschicht (4) eine SiGe-Kristallschicht ist.

9. Halbleitereinrichtung nach einem der vorhergehenden Ansprüche, bei der die Verbindungshalbleiterschicht (3b) AlGaAs, InGaAs, GaAsP oder InGaAsP ist.

10. Halbleitereinrichtung nach Anspruch 6, bei der die Halbleitereinrichtung ein MESFET, HEMT, eine Photodiode oder ein Laser ist.

11. Halbleitereinrichtung nach einem der vorhergehenden Ansprüche, bei der die erste Pufferschicht (3a) AlGaAs, InGaAs, GaAsP oder InGaAsP ist.

## Revendications

1. Dispositif semi-conducteur comprenant :
un substrat cristallin (1) fabriqué en silicium (Si), saphir ou MgO ;
une première couche tampon (3a) formée sur ledit substrat cristallin et étant une couche semiconductrice soit d'arséniure de gallium soit d'un composé contenant de l'arséniure de gallium;
une seconde couche tampon (4) formée sur ladite première couche tampon (3a) et étant une couche cristalline soit de germanium soit une couche contenant du germanium ; et
une couche semi-conductrice composée (3b) formée sur ladite seconde couche tampon (4) et étant une couche semi-conductrice soit d'arséniure de gallium soit d'un composé contenant de l'arséniure de gallium.

2. Dispositif semi-conducteur selon la revendication 1, dans lequel ladite seconde couche tampon (4) a une épaisseur comprise dans l'intervalle de 5 à 200 nm.

3. Dispositif semi-conducteur selon la revendication 1 ou 2, dans lequel ladite première couche tampon (3a) a une épaisseur comprise dans l'intervalle de 1 à 3 µm.

4. Dispositif semi-conducteur selon la revendication 1, 2 ou 3, dans lequel ladite couche semi-conductrice composée (3b) a une densité de défauts cristallins de 1 x 10⁶/cm² ou moins.

5. Dispositif semi-conducteur selon la revendication 1, 2, 3, ou 4, dans lequel ladite seconde couche tampon (4) est de type n et ladite couche semiconductrice composée (3b) est de type p ou i.

6. Dispositif semi-conducteur selon la revendication 1, 2, 3 ou 4, dans lequel ladite seconde couche tampon (4) est une couche de type p, et ladite couche semi-conductrice composée (3b) est de type n.

7. Dispositif semi-conducteur selon la revendication 5, dans lequel ledit dispositif semiconducteur est un MES FET, un HEMT, une photodiode, ou un laser.

8. Dispositif semi-conducteur selon l'une quelconque des revendications précédentes, dans lequel ladite seconde couche tampon (4) est une couche cristalline de SiGe.

9. Dispositif semi-conducteur selon l'une quelconque des revendications précédentes, dans lequel ladite couche semi-conductrice composée (3b) est d'AlGaAs, d'InGaAs, de GaAsP ou d'InGaAsP ;

10. Dispositif semi-conducteur selon la revendication 6, dans lequel ledit dispositif semiconducteur est un MES FET, un HEMT, une photodiode ou un laser.

11. Dispositif semi-conducteur selon l'une quelconque des revendications précédentes, dans lequel ladite première couche tampon (3a) est d'AlGaAs, d'InGaAs, de GaAsP ou d'InGaAsP.
